(19) **Europäisches Patentamt**

**European Patent Office**

**Office européen des brevets**

(11) Veröffentlichungsnummer: **0 197 516 B1**

(12) # EUROPÄISCHE PATENTSCHRIFT

(45) Veröffentlichungstag der Patentschrift: **26.02.92**

(21) Anmeldenummer: **86104569.8**

(22) Anmeldetag: **03.04.86**

(51) Int. Cl.⁵: **H05K 7/14**, H05K 5/00, H05K 3/36

(54) **Verfahren zur Herstellung von elektronischen Geräten.**

(30) Priorität: **11.04.85 DE 3512978**

(43) Veröffentlichungstag der Anmeldung:
**15.10.86 Patentblatt 86/42**

(45) Bekanntmachung des Hinweises auf die
Patenterteilung:
**26.02.92 Patentblatt 92/09**

(84) Benannte Vertragsstaaten:
**CH FR IT LI NL SE**

(56) Entgegenhaltungen:
**WO-A-82/04161**
**US-A- 4 085 433**

**EDN, Band 25, Nr. 14, August 1980, Seiten 51-54, Denver, Colorado, US; D. ZESKIND "Matchbox-sized TVs loom closer, thanks to innovative packaging"**

(73) Patentinhaber: **SCHALLER-AUTOMATION Industrielle Automationstechnik KG**
**Industriering 14**
**W-6653 Blieskastel(DE)**

(72) Erfinder: **Schaller, Werner, Dipl.-Ing.**
**Industriering 14**
**W-6653 Blieskastel(DE)**

EP 0 197 516 B1

# Beschreibung

Die Erfindung bezieht sich auf ein Verfahren zur Herstellung von elektronischen Geräten, bei dem eine flexible, mit der geätzten Schaltung versehene Leiterfolie nach dem Bestücken mit den elektronischen Bauelementen an vorbestimmten Faltabschnitten zur Anpassung an die Geräteform zusammengefaltet und diese Schaltungseinheit in ein, die geometrische Geräteform abbildendes Formwerkzeug eingelegt und mit einem plastischen, aushärtenden Kunststoff zu einem Gehäusekörper umhüllt wird und anschließend der aus den einzelnen Falt abschnitten bestehende ausgehärtete Gehäusekörper entlang einer Ausreißperforation herausgelöst wird.

Bei einem solchen Verfahren ist es bekannt, eine Vielzahl gleicher Schaltungen nebeneinander und hintereinander auf der von der Bandrolle abgewickelten dünnen flexiblen Leiterfolie auszuätzen und mit den einzelnen elektronischen Bauelementen zu bestücken. Nach dem Bestücken und Löten der Bauelemente werden die einzelnen Schaltungen entlang einer den Schaltungsumriß bestimmenden Perforation von Hand aus der Leiterfolie herausgerissen und anschließend an den Faltkanten zusammengefaltet.

Nach EDN, Band 25, Nr.14; August 1980, Seiten 51-54, Denver, Colorado, USA; D.Zeskind " Matchbox-sized TVs loom closer, thanks to innovative packaging ", ist es auch bekannt ganze, vorgefertigte Teilschaltungseinheiten in Form von Hybrid-Schaltungen auf flexible Folien mit ausgestanzten Konturen der Gesamtschaltung aufzubonden, um die elektrischen Verbindungen zwischen den Teilschaltungseinheiten herzustellen, dann die aufgebondeten Teilschaltungseinheiten zu einer kompakten Einheit zu falten und anschließend in ein Package Gehäuse hermetisch dicht einzulöten.

Ein weiteres ähnlichen Verfahren zur Herstellung von kompakten elektronischen Schaltungsmodulen wird in der japanischen Patentschrift WO 82/04 161 (1) [ WO-A-8 204 161], KONAMI INDUSTRIES beschrieben. Auch hier werden vorgefertigte flexible Schaltungsfolien mit den endgültigen Schaltungskonturen mit einzelnen Bauelementen bestückt, insbesondere auch integrierten Schaltkreisen, dann gefaltet oder gerollt, dann in vorgefertigte Gehäuse eingelegt und anschließend zur Stabilisierung und Abkapselung gegen Umwelteinflüsse mit Harz vergossen.

Auch die US Patentschrift 40 85 433 (1), Conrad J.Baranowski, befaßt sich mit einer Methode zur Herstellung von kompakten, elektronischen Schaltunsmodulen, wobei ebenfalls flexible Schaltungsfolien, welche bereits die äußeren Konturen aufweisen, mit einzelnen Bauelementen bestückt und dann so gefaltet werden, daß durch besonders günstige Interlokation das im Innern einer V-förmig gefalteten flexiblen Schaltung möglichst dicht mit dem Volumen von nach dem Falten ineinander verschachtelten Bauelementen ausgefüllt wird.

Gegenüber der Verwendung von starren Leiterplatten haben faltbare flexible Leiterfolien den Vorteil, daß man die von der üblichen flachbestückten Schaltung eingenommene, in einer ebene liegende große Fläche durch das Falten unterteilen und durch Übereinanderlegen der Faltabschnitte beliebig verkleinern kann.

Wenn man starre Leiterplatten so unterteilt, müßte man die einzelnen Schaltungseinheiten wieder gesondert über Drähte elektrisch miteinander verbinden, was bei Verwendung der gefalteten flexiblen Leiterfolie entfällt.

Um jedoch bei der Schaltung auf flexibler Leiterfolie eine Beschädigung der Leiterzüge sowie der eingelöteten Bauelemente und auch der flexiblen Leiterfolie selbst zu vermeiden, muß das Heraustrennen der bestückten und gelöteten Einzelschaltungen aus einer mehrere Schaltungen beinhaltenden größeren flexiblen Folie und das Falten der einzelnen, ausgetrennten oder bereits auf ausgestanzten Einzelfolien bestückten Schaltungen sorgfältig unter entsprechendem Zeitaufwand erfolgen. Die zusammengefaltete flexible Leiterfolie ist außerdem nicht sehr formstabil, so daß das Fixieren der Schaltung in einem Formwerkzeug, in dem eine Umhüllung mit Kunststoff, z.B. das Umschäumen mit Polyurethanschaum geschieht, nicht ganz einfach ist. Da das Herauslösen aus einer größeren Folie entlang einer Abreißperforation und Falten der Schaltung sowie das Einlegen in die Umhüllungsform und das Lagefixieren die volle Fingerfertigkeit einer Person erfordert, lassen sich diese Arbeitsgänge kaum und wenn, nur mit größten Aufwand automatisch durchführen.

Aufgabe der Erfindung ist es, das Herauslösen der bestückten und gelöteten Folienschaltung aus dem flexiblen Leiterfolienband und das Falten sowie das Einlegen der Schaltung in die Umhüllungsform und das Fixieren der Schaltung in der Form selbst wesentlich zu vereinfachen.

Die Lösung dieser Aufgabe wird in den Merkmalen der Patentansprüche gesehen.

Dadurch, daß gemäß den Merkmalen des Verfahrensanspruchs 1 der aus dem plastischen, aushärtbaren Kunststoff gebildete Gehäusekörper so in Gehäuseteilstücke unterteilt wird, daß sich diese Gehäuseteilstücke beim Falten der Leiterfolie zu dem geschlossenen Gehäusekörper ineinanderfügen lassen, wird die Möglichkeit geschaffen, die im Bereich eines jeden Faltabschnittes liegenden elektronischen Bauelemente für sich vor dem Falten in Einzelkunststofformteile einzubetten und somit die Gehäuseteilstücke zu bilden. Zu diesem Zweck werden die Gehäuseteilstücke als Einzelkunststofformteile auf die Faltabschnitte der ebenen, noch ungefalteten Leiterfolie aufgebracht, so daß sich bereits vor dem Falten versteifte, die Bauelemente, die Lötung und die Folie selbst schützende Klappstücke ergeben, die sich ohne besondere Sorgfalt und Fingerfertigkeit in einfacher Weise entlang einer Abreißperforation, welche den aus den einzelnen Faltabschnitten bestehenden Gehäusekörper umschließt und die äußere Kontur der Gesamtschaltung bildet, herauslösen und zu dem geschlossenen Gehäuse an den flexiblen Faltstreifen ineinanderklappen lassen.

Das Aufbringen der Gehäuseteilstücke läßt sich durch die Merkmale des Anspruchs 2 automatisieren, so daß ein Eingreifen von Hand nicht mehr erforderlich ist.

Eine besonders zweckmäßige Unterteilung des Gehäusekörpers ergibt sich durch die Merkmale des Verfahrensanspruchs 3, da die aufeinander zur Anlage kommenden Lötseiten der Faltabschnitte durch die Isolierzwischenschichten nicht nur ausreichend versteift und geschützt, sondern auch sicher gegen ungewollte elektrisch leitende Berührung abgesichert sind. Die bisher eingelegten besonderen Isoliertrennfolien können dadurch enfallen. Während die Isolierzwischenschichten zur Erzielung eines raumsparenden Faltens relativ dünn ausgebildet werden können, sind die die Bauelemente umschließenden Gehäuseteilstücke dadurch, daß sie gleichzeitig die Außenkonturen des Gehäusekörpers bilden, relativ dickwandig, wodurch sich auch größere Bauelemente bereits vor dem Falten voll einbetten und damit schützen lassen.

Als plastischer, aushärtbarer Kunststoff wird zweckmäßigerweise gemäß dem Verfahrensanspruch 4 ein Kunststoffschaum, insbesondere Polyurethanschaum verwendet, der nur in eine der beiden Formwerkzeughälften eingefüllt wird und sich über Durchtrittsöffnungen der Leiterfolie in die andere Formwerkzeughälfte ausbreitet. Der Kunststoffschaum umhüllt die Bauelemente durch seine Weichheit besonders schonend ohne beim Ausfüllen der Formhohlräume einen Schiebedruck auf die durchlöcherte Leiterfolie und die Bauelemente auszuüben. Über die Durchtrittsöffnungen sind die gegenüberliegenden, gemeinsam ausgeformten Gehäuseteilstücke auch direkt miteinander verbunden, so daß ein besonderer Hafteffekt zwischen Leiterfolie und Kunststoff nicht unbedingt erforderlich ist.

Durch die schnapperartige Verbindung der Gehäuseteilstücke gemäß dem Anspruch 5 werden die Gehäuseteilstücke mit den eingebetteten Schaltungsfaltabschnitten beim Ineinanderfalten ohne zusätzliche Maßnahmen präzise zueinander fixiert und gleichzeitig sicher zu einem geschlossenen Gehäusekörper miteinander verbunden.

Ein spannungsfreies, leichtes Falten der mit Kunststoff umhüllten Faltabschnitte läßt sich entsprechend dem Gehäusekörper nach Anspruch 6 dadurch erreichen, daß zwischen den benachbarten Kunststoff-Gehäuseteilstücken ein Faltstreifen freibleibt, dessen Breite der Höhe der nach dem Falten dazwischenliegenden Isolierzwischenschichten angepaßt ist.

Wird die Leiterfolie gemäß den Merkmalen des Anspruchs 7 durch parallel und/oder senkrecht dazu verlaufende Faltstreifen in mehrere rechteckige Faltabschnitte unterteilt und werden hierauf tafelförmige Kunststoff-Gehäuseteilstücke aufgebracht, so lassen sich die Faltabschnitte der Leiterfolie in Sandwichbauweise ohne zusätzliche Maßnahme leicht zu einem direkt praktisch verwendbaren elektronischen Modul zusammenfalten.

Sind die von der Bestückungsseite der Leiterfolie her aufgebrachten Gehäuseteilstücke entsprechend Anspruch 8 mit eingeformten Ausnehmungen versehen, in die sich Faltabschnitte mit kleineren Gehäuseteilstücken einklappen lassen, kann auf diese Weise ein Bauelement unabhängig von der senkrecht zur Bestückungsebene erfolgenden Bestückung der eben gespannten Leiterfolie in jede gewünschte Endlage gekippt werden.

Sind die Faltabschnitte, die mit ihrem aufgebrachten Kunststoff-Gehäuseteilstück unabhängig von einer Faltkante örtlich versetzt in den Gehäusekörper eingefügt werden sollen, gemäß dem Merkmal des Anspruchs 9 über freie zungenartige Verbindungsstege der Leiterfolie mit der übrigen Schaltung auf der Leiterfolie verbunden, so lassen sie sich völlig freizügig in jeder gewünschten Position und Lage anordnen.

Um die sich zwischen den zusammengefügten Gehäuseteilstücken ergebenden Trennfugen sowie die freien Faltstreifen und gegebenenfalls die zungenartigen Verbindungsstege nach außen dichtend abzuschließen und den aus den Teilstücken bestehenden Gehäusekörper in sich zu verfestigen, wird gemäß dem Anspruch 10 außerdem vorgeschlagen, die zusammengefügten Gehäuseteilstücke durch eine Geräteaußenhülle aus Kunststoff zu ummanteln.

Zu diesem Zweck kann der zusammengefügte Gehäusekörper entsprechend Anspruch 11 auch in ein vorgefertigtes Außengehäuse eingeschoben werden, das durch einen Deckel an der Einschieböffnung verschlossen wird, wodurch ein billiges Kunststoff-Spritzgehäuse oder ein Metall-Tiefziehgehäuse verwendet werden kann.

Die Gehäuseteilstücke lassen sich mit dem Formwerkzeug nach Anspruch 12 in besonders einfacher Weise dadurch auf die noch ebene aber bestückte Leiterfolie aufbringen, daß die Fallabschnitte an den Faltstreifen sowie an den durch eine Abreißperforation gebildeten Randstreifen dicht zwischen Stege der Formwerkzeughälften straff eingespannt sind, wodurch die einzelnen Faltabschnitte fest in der Form arretiert sind und die Gehäuseteilstücke eine exakte und saubere Randbegrenzung erhalten. Die Vertiefungen in den Formwerkzeughälften auf der Bestückungsseite und der Lötseite der Leiterfolie sind hierbei genau den für die einzelnen Faltabschnitte erforderlichen räumlichen Konturen angepaßt, so daß beim Ausfüllen der Formhohlräume mit plastischem aushärtbarem Kunststoff alle Bauelemente ihre festgelegte Position genau beibehalten und beim Aushärten des Kunststoffes in diesen, sie umhüllenden Kunststoff,integriert sind.

Dadurch, daß gemäß Anspruch 13 die Formwerkzeughälften für alle Faltabschnitte zu einer gemeinsamen unteren und oberen Gesamtformwerkzeughälfte zusammengefaßt sind, lassen sich mit einer Form alle Gehäuseteilstücke gleichzeitig in einfacher Weise herstellen.

Werden die Leiterfolie und die Formwerkzeuge entsprechend dem Merkmal des Anspruchs 14 mit deckungsgleichen Zentrierungen versehen, wird gewährleistet, daß die Schaltungsabschnitte stets exakt an der gleichen Stelle abgeformt werden.

Die Erfindung wird anhand von Ausführbeispielen näher erläutert, die die Zeichnung erkennen lassen, und zwar zeigt :

Fig. 1 eine bekannte, mit Bauelementen bestückte Leiterfolie ungefaltet,

Fig. 2 die gleiche bekannte Leiterfolie zusammengefaltet mit angedeuteten Konturen des noch aufzubringenden Gehäusekörpers,

Fig. 3 die in die untere Formwerkzeughälfte eingelegte bekannte gefaltete Schaltung nach Fig. 2 vor dem Umhüllen,

Fig. 4 zwei übereinander liegende Formwerkzeughälften in perspektivischer Darstellung mit der dazwischen gespannten bestückten Leiterfolie nach Aufbringen der erfindungsgemäßen Gehäuseteilstücke,

Fig. 5 den aus der Form nach Fig. 4 entnommenen, aus den Gehäuseteilstücken zusammen-gefügten Gehäusekörper kurz vor Einfügen des letzten Teilstückes,

Fig. 6 einen Schnitt durch den Gehäusekörper nach Fig. 5 im Bereich des noch einzuschwenkenden letzten Teilstückes,

Fig. 7 den Schnitt nach Fig. 6 mit eingeschwenktem letzten Teilstück,

Fig. 8 quaderförmige, die hintereinanderliegenden rechteckigen Faltabschnitte einer Leiterfolie umhüllende Gehäuseteilstücke eines Gehäusekörpers vor dem Falten,

Fig. 9 die in Fig. 8 gezeigten Gehäuseteilstücke nach dem Falten und Aufbringen einer zusätzlichen Geräteaußenhülle und

Fig. 10 den Gehäusekörper nach Fig. 9 im Querschnitt.

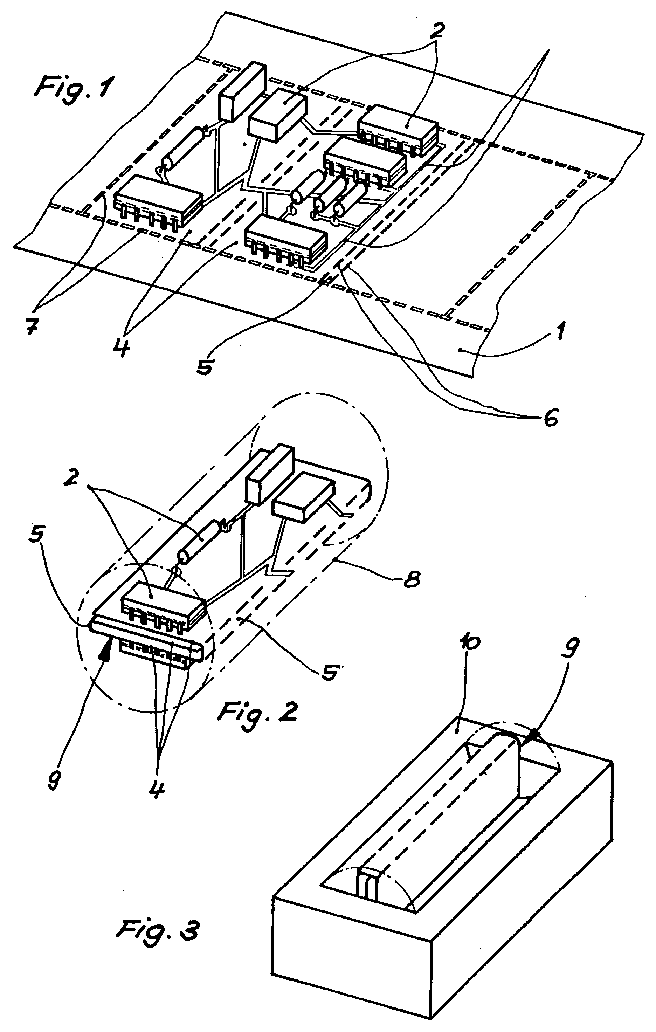

Auf der in der Fig. 1 gezeigten Leiterfolie 1 ist die aus den elektronischen Bauelementen 2 und den geätzten Leiterzügen 3 bestehende elektrische Schaltung aufgebracht. Diese bekannte flexible Schaltung ist zur Unterteilung der einzelnen Faltabschnitte 4 mit Faltstreifen 5 versehen, die durch Perforationen 6 markiert sind, um das Falten der Leiterfolie 1 zu erleichtern. Der äußere Rand der Schaltung wird durch die Abreißperforation 7 gebildet.

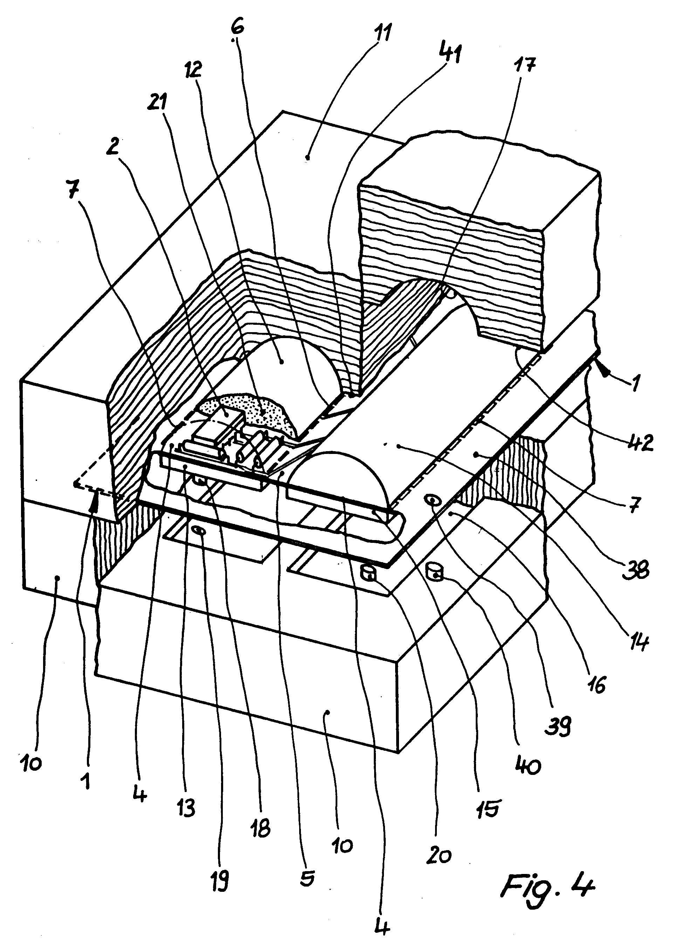

Die Fig. 2 zeigt die aus der Leiterfolie 1 herausgerissene Schaltung mit an den Faltstreifen 5 gefalteten Faltabschnitten 4, so daß die einzelnen Faltabschnitte mit den Bauelementen 2 übereinander zu liegen kommen und der Platzbedarf für die Schaltung dadurch erheblich verringert wird. Die gewünschte Gehäuseform 8 des elektronischen Gerätes, die die gefaltete Schaltung 9 umhüllt, ist hier strichpunktiert angedeutet. Die Fig. 3 zeigt das bekannte Vonhandeinlegen der gefalteten Schaltung 9 in die untere Formwerkzeughälfte 10.

Aus der Fig. 4 ist das erfindungsgemäße Verfahren zur Herstellung der Gehäuseteilstücke ersichtlich. Die mit den Bauelementen 2 bestückte jedoch noch ungefaltete ebene Leiterfolie 1 ist straff zwischen der unteren Formwerkzeughälfte 10 und der oberen Formwerkzeughälfte 11 eingespannt. Die Leiterfolie 1 trägt die aus den Faltabschnitten 4 gebildete Schaltung, zwischen denen die Faltstreifen 5 mit den beiden Faltperforierungen 6 vorgesehen sind. Die Außenbegrenzung der Schaltung wird durch die Abreißperforation 7 gebildet. Der Gehäusekörper des elektronischen Gerätes ist in die Gehäuseteilstücke 12, 13, 14 und 15 unterteilt, die sich beim Falten der Schaltung zu dem geschlossenen Gehäusekörper ineinanderfügen lassen.

Zur Ausbildung dieser Gehäuseteilstücke ist die untere Formwerkzeughälfte 10 mit Vertiefungen 16 versehen, die die Isolierzwischenschichten 13 und 15 ausformen. Die obere Formwerkzeughälfte 11 trägt im Bereich der beiden Faltabschnitte 4 halbzylinderförmige Vertiefungen 17, die die der Außenkontur des Gehäusekörpers angepaßten Halbzylinder-Teilstücke 12 und 14 ausformen, die zusammen ein zylindrisches Gehäuse ergeben. Die Formhälften 10 und 11 sind zum besseren Verständnis teilweise in angehobener Stellung nach Aushärten des Kunststoffes gezeichnet. Zum Zusammenhalten der beiden Gehäusekörperhälften 12, 13 und 14, 15 nach dem Falten sind an der Isolierzwischenschicht 13 Zapfen 18 durch Formlöcher 19 angeformt, die in durch die Zapfen 20 der unteren Formwerkzeughälfte 10 gebildete Schnapplöcher klemmend eingreifen. Als Kunststoff ist hier ein Polyurethanschaum 21 vorgesehen, der die Bauelemente 2 besonders schützend umschließt. Die bestückte Leiterfolie 1 weist in den Randstreifen 38 Zentrierlöcher 39 auf und die Formwerkzeughälfte 10 ist mit Zentrierstiften 40 versehen, die in entsprechende Bohrungen der anderen Gehäuseformhälfte 11 eingreifen. Zur dichten Auflage der Formwerkzeughälften 10 und 11 auf den Faltstreifen 5 und den Randstreifen 38 der Leiterfolie 1 besitzen die Formwerkzeughälften Innenstege 41 und Randstege 42.

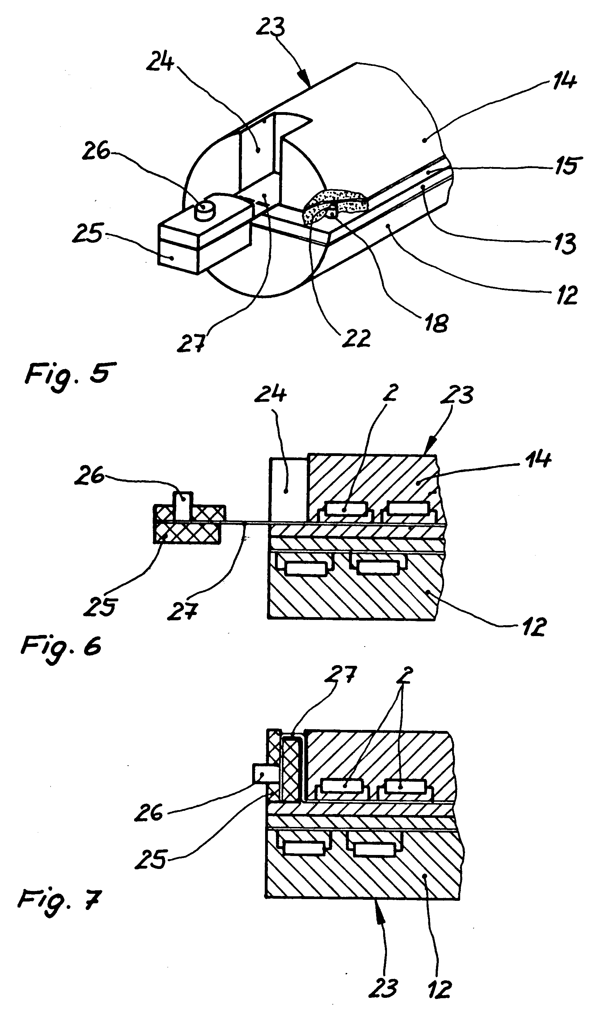

Die aus dem in der Fig. 4 gezeigten Formwerkzeug entnommene und entlang der Ausreißperforation 7 aus der Leiterfolie 1 herausgetrennte Schaltung ist zu einem zylindrischen Gehäusekörper zusammengefügt, wie die Fig. 5 zeigt. Die Zapfen 18 der Isolierzwischenschicht 13 greifen hier in die Löcher 22 der Isolierzwischenschicht 15 ein und halten den Gehäusekörper 23 zu einem Zylinder zusammen. Das obere Halbzylinderteilstück 14 trägt eine Ausnehmung 24, in die noch das Gehäuseteilstück 25 einzuschwenken ist. Das Gehäuseteilstück 25 umhüllt die Bauelemente eines besonderen Faltabschnittes, der zwar in der Ebene der Leiterfolie 1 mit den Bauelementen 2 bestückt, aber als Gehäuseteilstück um 90˚ gedreht zu den anderen Teilstücken in den Gehäusekörper 23 eingefügt werden soll, damit z.B. eine Leuchtdiode 26 nach außen in den Sichtbereich zu liegen kommt. Die elektrische Verbindung des Gehäuseteilstückes 25 mit der übrigen Schaltung erfolgt über die flexible Leiterfolienzunge 27, die durch eine besondere Kontur der Abreißperforation 7 hergestellt ist.

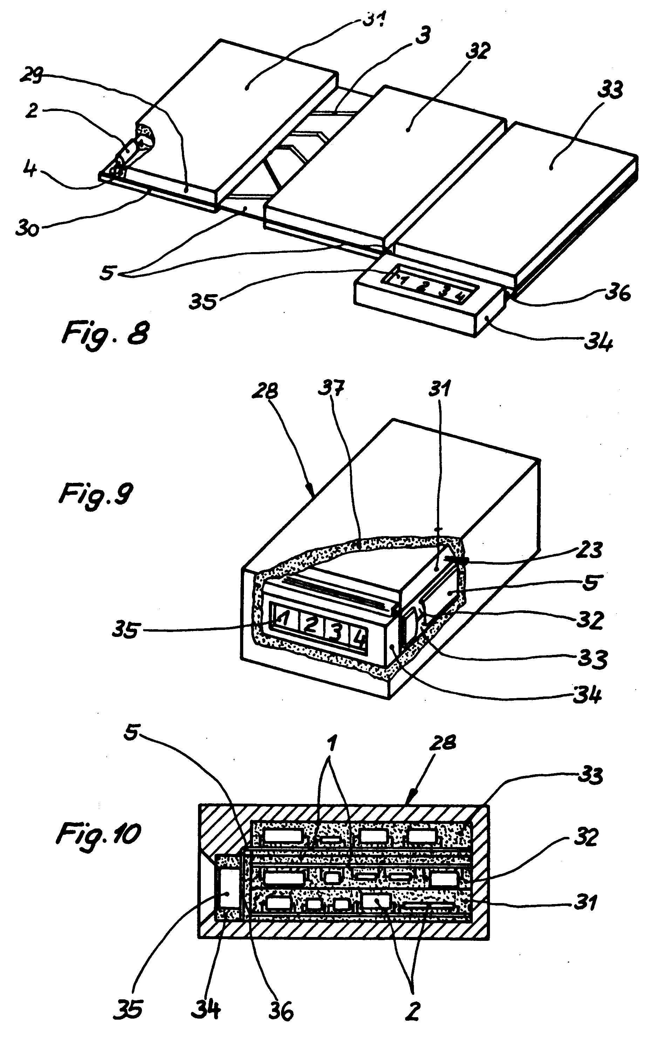

Die Fig. 6 zeigt das Gehäuseteilstück 25 im Schnitt, bevor es in die Ausnehmung 24 des Gehäuseteilstückes 14 eingefügt worden ist. Aus der Fig. 7 geht der geschlossene Gehäusekörper 23 mit eingefügtem Gehäuseteilstück 25 hervor, wobei die Zunge 27 so gefaltet ist, daß die Leuchtdiode 26 nach außen zu liegen kommt.

In den Fig. 8 bis 10 ist ein Ausführungsbeispiel für ein elektrisches Anzeigegerät mit einer Geräteaußenhülle 28 dargestellt. Die einzelnen rechteckförmigen Faltabschnitte 4 mit den Bauelementen 2 sind hier durch die von beiden Seiten her aufgebrachten Kunststoffschaumschichten 29 und 30 jeweils zu flachen, quaderförmigen Gehäuseteilstükken 31 bis 34 zusammengefaßt, wie die Fig. 8 zeigt. Während die Gehäuseteilstücke 31, 32 und 33 in Reihe hintereinander liegen und parallel zueinander verlaufende Faltstreifen 5 mit Verbindungs-Leiterzügen 3 zwischen sich haben, ist das Gehäuseteilstück 34 mit einer LED-Anzeige 35 über einen rechtwinklig zu den übrigen Faltstreifen 5 verlaufenden Faltstreifen 36 mit der übrigen Schaltung verbunden.

Aus den Fig. 9 und 10 sind die zieharmonikaartig zur Sandwichbauweise zusammen geklappten Gehäuseteilstücke 31 bis 33 ersichtlich, wobei das Anzeigeteilstück 34 stirnseitig auf das Sandwichpaket 31 bis 33 geklappt ist. Die zur Versteifung des Gehäusekörpers 23 vorgesehene, das Sandwichpaket 31 bis 34 umschließende, Geräteaußenhülle 28 wird hier ebenfalls durch eine Schaumschicht 37 gebildet.

**Patentansprüche**

1. Verfahren zur Herstellung von elektronischen Geräten, bei dem eine flexible, mit einer geätzten Schaltung versehene Leiterfolie (1) nach dem Bestücken mit den elektronischen Bauelementen (2) an vorbestimmten Faltabschnitten (4) in ein zur Anpassung in ein die geometrische Geräteform abbildendes Formwerkzeug (10,11) eingelegt wird und mit einem plastischen, aushärtenden Kunststoff zu Gehäuseteilstücken (12-15,25,31-34) umhüllt wird, wobei der aus dem plastischen, aushärtenden Kunststoff gebildete Gehäusekörper (23) so in Gehäuseteilstücke unterteilt wird, daß sich die Gehäuseteilstücke (12-15,25) beim Falten der Leiterfolie (1) zu dem geschlossenen Gehäusekörper ineinander fügen lassen, und diese Gehäuseteilstücke als Einzelkunststoff-Formteile auf die Faltabschnitte der ebenen, noch ungefalteten aber bestückten Leiterfolie aufgebracht und anschließend der aus den einzelnen Faltabschnitten bestehende Gehäusekörper entlang einer Ausreißperforation herausgelöst wird.

2. Verfahren nach Anspruch 1, **dadurch gekennzeichnet,** daß die Formwerkzeughälften einem laufenden, mit den eingelöteten Bauelementen der Schaltungen bestückten Folienband einerseits von der Bestückungsseite und andererseits von der Lötseite her automatisch genähert und auf die Faltabschnitte aufgesetzt werden und anschließend plastischer Kunststoff in die Formhohlräume eingebracht wird, wobei die Formwerkzeughälften während der Aushärtezeit des Kunststoffes die Weiterbewegung des Bandes mitmachen und danach wieder automatisch geöffnet und in die Ausgangsstellung zurückgeführt werden.

3. Verfahren nach Anspruch 1 oder 2, **dadurch gekennzeichnet,** daß auf die Faltabschnitte von der Bestückungsseite der Leiterfolie her die die Außenkonturen des Gehäusekörpers abbildenden Gehäuseteilstücke und von der Lötseite her als Gehäuseteilstücke Isolierzwischenschichten aufgebracht sind und beim Falten die Isolierzwischenschichten der Faltabschnitte aufeinandergelegt werden.

4. Verfahren nach einem oder mehreren der Ansprüche 1 bis 3, **dadurch gekennzeichnet,** daß als plastischer, aushärtbarer Kunststoff ein Kunststoffschaum verwendet wird, der nur in eine der beiden Formwerkzeughälften eingefüllt wird, und die Leiterfolie im Innenbereich der Faltabschnitte mit Durchtrittsöffnungen für den Kunststoffschaum versehen ist.

5. Verfahren nach einem oder mehreren der Ansprüche 1 bis 4, **dadurch gekennzeichnet,** daß die Teilstücke (12-15,25,31-34) des Gehäusekörpers (23) beim Ineinanderfügen zur geschlossenen Gehäuseform an ihren Berührungsflächen durch angeformte vorspringende Zapfen (18) und gegenüberliegende Vertiefungen (22) schnapperartig miteinander verbunden sind.

6. Verfahren nach einem oder mehreren der Ansprüche 1 bis 5, **dadurch gekennzeichnet,** daß auf der Leiterfolie (1) zwischen den benachbarten Kunststoff-Gehäuseteilstücken (12,14 bzw. 13,15) ein Faltstreifen (5) frei bleibt, dessen Breite der Höhe der nach dem Falten dazwischenliegenden Isolierzwischenschichten (13,15) angepaßt ist.

7. Verfahren nach einem oder mehreren der Ansprüche 1 bis 6, **dadurch gekennzeichnet,** daß die Leiterfolie (1) durch parallel und/oder senkrecht dazu verlaufende Faltstreifen (5) in mehrere rechteckige Faltabschnitte (4) unterteilt ist, auf die tafelförmige Kunststoff-Gehäuseteilstücke (31-33) aufgebracht sind, die in Sandwichbauweise zum geschlossenen Gehäusekörper (23) übereinandergefaltet sind.

8. Verfahren nach einem oder mehreren der Ansprüche 1 bis 7, **dadurch gekennzeichnet,** daß die von der Bestückungsseite (2) der Leiterfolie (1) her aufgebrachten Gehäuseteilstücke (12,14) des Gehäusekörpers (23) mit eingeformten Ausnehmungen (24) versehen sind, in die sich Faltabschnitte mit kleineren Gehäuseteilstücken (25) einklappen lassen.

9. Verfahren nach einem oder mehreren der Ansprüche 1 bis 8, **dadurch gekennzeichnet,** daß Faltabschnitte (4), die mit ihrem aufgebrachten Kunststoff-Gehäuseteilstück (25) örtlich versetzt in den Gehäusekörper (23) eingefügt werden sollen, über freie zungenartige Verbindungsstege (27) der Leiterfolie (1) mit der übrigen Schaltung (2,3) auf der Leiterfolie (1) verbunden sind.

10. Verfahren nach einem oder mehreren der Ansprüche 1 bis 9, **dadurch gekennzeichnet,** daß die zu dem geschlossenen Gehäusekörper (23) ineinandergefügten Teilstücke (31-34) durch einen plastischen, aushärtenden und die Geräteaußenhülle (28) bildenden Kunststoff ummantelt sind.

11. Verfahren nach einem oder mehreren der Ansprüche 1 bis 9, **dadurch gekennzeichnet,** daß die zu dem geschlossenen Gehäusekörper (23) ineinandergefügten Teilstücke (12-15, 23,31-34) in ein vorgefertigtes Außengehäuse eingeschoben sind und das Außengehäuse durch einen Deckel an der Einschieböffnung verschlossen ist.

12. Verfahren zur Herstellung eines Gehäusekörpers nach einem oder mehreren der Ansprüche 1 bis 11 , **dadurch gekennzeichnet**, daß der plastische aushärtende Kunststoff (21) in die auf der Bestückungsseite und der Lötseite der Leiterfolie (1) im Bereich der Faltabschnitte (4) der Kontur der Gehäuseteilstücke (12-15) angepaßte, durch die Stege (41,42) begrenzte Vertiefungen (16,17) aufweisende Formwerkzeughälften (10,11) aufgenommen wird und die Faltabschnitte (4) der ebenen, noch ungefalteten aber bestückten- Leiterfolie (1) an den Faltstreifen (5) sowie an den durch eine Abreißperforation (7) gebildeten Randstreifen (38) dicht zwischen Innen- und Randstegen (41,42) der Formwerkzeughälften (10,11) eingespannt sind.

13. Verfahren zur Herstellung eines Gehäusekörpers nach Anspruch 12 **dadurch gekennzeichnet**, daß für alle Faltabschnitte (4) die Formwerkzeughälften (10,11) zu einer gemeinsamen unteren und oberen Gesamtwerkzeughälfte zusammengefaßt sind.

14. Verfahren zur Herstellung eines Gehäusekörpers nach den Ansprüchen 12 und 13 **dadurch gekennzeichnet**, daß Zentrierstifte (40) und Zentrierbohrungen aufweisende Formwerkzeughälften (10,11) deckungsgleich mit Zentrierlöchern (3q) in den Falt- oder Randstreifen (5,38) der bestücken Leiterfolie (1) versehen sind.

**Claims**

1. Procedure for the manufacture of electronic units during which a flexible conductor foil (1) provided with an etched circuit is placed, after the electronic components (2) are inserted at predetermined folding sections (4), for adjustment into a forming tool (10,11) outlining the geometrical form of the unit and is enclosend with a curing plastic to form casing parts (12 - 15, 25, 31 - 34), with the casing body (23) made of curing plastic being divided into casing parts in such a way that the casing parts (12-15, 25) can, when folding the conductor foil, be fitted into aech other to form the closed casing body and these casing parts ale applied as single plastic mouldings to the folding sections of the plain and still unfolded, but equipped conductor foil and subsequently the casing body consisting of the individual folding sections is detached along a tear-up perforation.

2. Procedure according to claim 1, characterized by the forming tool halves being automatically approached to a running foil band equipped with the soldered circuit components , on the one hand from the insertion side and on the other hand from the solder side, and being put onto the folding sections, and subsequently plastic being poured into the form hollows with the forming tool halves following the onward movement of the band during the curing period of the plastic and then being reopened automatically and restored to the starting position.

3. Procedure according to claim 1 or 2, characterized by the casing parts forming the outlines of the casing body being applied onto the folding sections from the insertion side of the conductor foil and by intermediate insulating layers being applied as casing parts from the solder side and by the intermediate insulating layers of the folding sections being superposed when folding.

4. Procedure according to one or several of the claims 1 to 3, characterized by a plastic foam being used as curing plastic, which is only filled into one of the two forming tool halves, and by the conductor foil being provided with openings for penetration of the plastic foam in the inner areas of the folding sections.

5. Procedure according to one or several of the claims 1 to 4, characterized by the parts (12-15, 25, 31-34) of the casing body (23), when fitted into each other to form the closed casing, being joined with each other like a snap at their contact surfaces by means of preformed protruding pivots (18) and opposite recesses.

6. Procedure according to one or several of the claims 1 to 5, characterized by a folding strip (5) remaining free on the conductor foil (1) between the adjacent plastic casing parts (12, 14 and 13, 15, respectively) the width of which is adapted to the height of the intermediate insulating layers (13, 15) after folding.

7. Procedure according to one or several of the claims 1 to 6, characterized by the conductor foil (1) being divided by folding strips (5) running in parallel or vertical to it into several rectangular folding sections (4), onto which tabular plastic casing parts (31-33) are applied which are folded one upon another in sandwich construction to form the closed casing body (23).

8. Procedure according to one or several of the claims 1 to 7, characterized by the casing parts (12, 14) of the casing body (23) applied from the inserton side (2) of the conductor foil (1) being provided with moulded recesses (24) into which folding sections with smaller casing parts (25) can be collapsed.

9. Procedure according to one or several of the claims 1 to 8, characterized by folding sections (4), which should, with their applied plastic casing part (25), be inserted locally staggered into the casing body (23), being linked by free, tongue-shaped connecting bars (27) of the conductor foil (1) with the rest of the circuit (2,3) on the conductor foil (1).

10. Procedure according to one or several of the claims 1 to 9, characterized by the parts (31-34) fitted into each other to form the closed casing body (23) being enclosed by a curing plastic constituting the outer cover of the unit.

11. Procedure according to one or several of the claims 1 to 9, characterized by the parts (12-15, 23, 31-34) fitted into each other to form the closed casing body (23) being pushed into a pre-fabricated casing shell and the casing shell being locked by a cover at the insertion opening.

12. Procedure for the manufacture of a casing body according to one or several of the claims 1 to 11, characterized by the curing plastic (21) being absorbed by forming tool halves (10,11) which are adapted on the insertion side and on the solder side of the conductor foil (1), in the area of the folding sections (4), to the outline of the casing parts (12-15) and which show receses (16,17) limited by the bars (41,42), and characterized by the folding sections (4) of the plain and still unfolded, but equipped conductor foil (1) being clamped to the folding strip (5) as well as to the marginal strip formed by a tear-up perforation (7), tightly between internal and marginal bars (41,42) of the forming tool halves (10,11).

13. Procedure for the manufacture of a casing body according to claim 12, characterized by the forming tool halves (10,11) for all folding sections (4) being comprised to a common lower and upper entire tool half.

14. Procedure for the manufacture of a casing body according to the claims 12 and 13, characterized by forming tool halves (10, 11) which have centre pins and centre bores, being congruently provided with centre holes (39) in the folding or marginal strips (5, 38) of the equipped conductor foil (1).

## Revendications

1. Procédure pour la fabrication des appareils électroniques durant une feuille conductrice (1) pourvu d'un circuit corrodé est placée, après être équipée des composantes éelectroniques (2) aux sections de pliage prédéterminées (4), pour adaption dans un outil de façonnage (10,11) reproduisant la forme géométrique de l'appareil et est envelopée d'un plastique durcisant pour former des éléments de boîte (12-15, 25, 31-34), avec le corps de boîte (23) formé du plastique durcissant étant subdivisé en éléments de boîte de telle sorte que les éléments de boîte (12-15,25) puissent, lors du pliage de la feuille conductrice, être emboîtes pour former un corps de boîte fermé, et ces éléments de boîte sont appliqués comme pièces façonnées en plastique individuel sur les sections de pliage de la feuille conductrice plate, encore non pliée, mais équipée, et ensuite le corps de boîte composé des sections de pliage individuelles est détaché le long d'une perforation pour arracher.

2. Procédure leon la spécifiction 1, caractérisée par le fait que les moités de l'outil de façonnage sont approchées automatiquement d'une bande roulante équipée des composantes de circuit soudés, d'une part du côté d'insertion et d'autre part du côté de soudure, et qu'elles sont posées sur les sections de pliage, et ensuite du plastique est versé dans les cavités de la forme avec les moitiés de l'outil de façonnage suivant le mouvement vers l'avant de la bande lors du temps de durcissement du plastique et ensuite se réouvrant automatiquement pour se remettre en position initiale.

3. Procédure selon le spécifiction 1 ou 2, caractérisée par le fait que les éléments de boîte reproduisant les contours du corps de boîte sont appliqués sur les sections de pliage du côté d'insertion de la feuille conductrice et des couches isolantes intermédiaires sont appliquées comme éléments de boîte dit côté de soudure et les couches isolantes intermédiaires des sections de pliage sont superposées lors du pliage.

4. Procédure selon une ou plusieurs des spécifications 1 à 3, caractérisée par le fait qu'une mousse en plastique est utilisée comme plastique durcissant qui est versée seulement dans une des deux moitiés de l'outil de façonnage et que la feuille conductrice se trouvant dans la partie intérieure des sections de pliage es pourvu d'ouvertures pour la pénétration de la mousse en plastique.

5. Procédure selon une ou plusieurs des spécifications 1 à 4, caractérisée par le fait que les éléments (12-15, 25, 31-34) du corps de boîte (23), lorsqu'ils sont emboîtés pour former une boîte fermée, sont joints l'un avex l'autre, comme un loqueteau, aux surfaces de contact à l'aide des chevilles saillantes préformées (18) et des creux situes face à elles

6. Procédure selon une ou plusieures des spécifications 1 à 5, caractérisée par le fait qu'une bande de pliage (5) reste libre sur la feuille conductrice (1) entre les éléments de boîte en plastique adjacents (12,14 et 13,15 respectivement), la largeur de laquelle est adaptée à la hauteur des couches isolant es intermédiaires (13,15) après pliage.

7. Procédure selon une ou plusieurs des spécifications 1 à 6, caractérisée par le fait que la feuille conductrice (1) est divisée en plusieurs sections de pliage rectangulaires (4) par des bandes de pliage (5) conseant parallélement et/ou perpendiculairement la feuille conductrice, et que sur ces sections de pliage rectangulaires, des éléments de boîte tabulaires en plastique (31-33) sont appliqués et pliés les uns sur les autres en construction "sandwich" pour former le corps de boite fermé (23).

8. Procédure selon une ou plusieurs des spécifications 1 à 7, caractérisée par le fait que les éléments de boîte (12,14) du corps de boîte (23) appliqués du côté d'insertion (2) de la feuille conductrice (1) sont pourvus des creux moulés (24) dans lesquels on peut plier des sections de pliage avec petits éléments de boîte (25).

9. Procédure selon une ou plusieurs des spécifications 1 à 8, caractérisée par le fait que les sections de pliage (4), qui doivent, avec leur élément de boîte appliqué en plastique (25), être insérées avec alternance dans le corps de boîte (23), sont liées par des traverses de raccordement (27), libres et sous forme de langues, de la feuille conductrice (1) au reste du circuit (2,3) sur la feuille conductrice (1).

10. Procédure selon une ou plusieurs des spécifications 1 à 9, caractérisée par le fait que les éléments (31-34) joints les uns dans les autres pour former le corps de boîte fermé (23) sont enveloppés par un plastique durcissant constituant le revêtement de l'appareil.

11. Procédure selon une ou plusieurs des spécifications 1 à 9, caractérisée par le fait que les éléments (12-15, 23, 31-34) joints les uns dans les autres pour former le corps de boîte fermé (23) sont glissés dans une boîte fermé préfabriquée et que la boîte est fermée par un couvercle situé à l'ouverture d'insertion.

12. Procédure pour la fabrication d'un corps de boîte selon une ou plusieurs des spécefications 1 à 11, caractérisée par le fait que le plastique durcissant (21) est absorbé par des moitiés de l'outil de façonnage et sur le côté de soudure de la feuille conductrice (1), dans la partie des sections de pliage (4), au contour des éléments de boîte (12-15) et qui présentent des creux limités par des traverses (41,42), et que les sections de pliage (4) de la feuille conductrice (1) plate, pas encore pliée, mais équipée, sont fixées à la bande de pliage (5) ainsi qu'à la bande marginale formée par une perforation de détachement (7), étroitement entre les traverses intérieures et marginales (41,42) des moitiés de l'outil de façonnage (10,11).

13. Procédure pour la fabrication d'un corps de boîte selon la spécification 12 caractérisée par le fait que les moitiés de l'outil de façonnage (10,11) pour toutes les sections de pliage (4) sont réunies pour former une moitié commune supérieure et inférieure de l'outil entier.

14. Procédure pour la fabrication d'un corps de boîte selon les spécifications 12 et 13 caractérisée par le fait que les moitiés de l'outil de façonnage (10,11) qui présentent des chevilles de centrage (40) et percements de centrage sont pourvues congrument de trous de centrage (39) dans les bandes de pliage ou les bandes marginales (5,38) de la feuille conductrice équipée (1).

Fig. 1

Fig. 2

Fig. 3

Fig. 4

Fig. 5

Fig. 6

Fig. 7

Fig. 8

Fig.9

Fig.10